# EUROPEAN PATENT APPLICATION

(11) **EP 2 527 487 A1**
(43) Date of publication of application: **28.11.2012**
(21) Application number: 12168951.7
(22) Date of filing: 22.05.2012
(51) Int. Cl.: C23C 14/08, C23C 14/34, H01J 37/34

(54) **Separated target apparatus for sputtering and sputtering method using the same**

(30) Priority: 23.05.2011 KR 20110048503
(71) Applicant: Samsung Display Co., Ltd., Yongin-City, Gyeonggi-Do, 446-711 (KR)
(72) Inventor: CHUNG, Yun-Mo, 446-711 Yongin-City (KR); LEE, Ki-Yong, 446-711 Yongin-City (KR); JEONG, Min-Jae, 446-711 Yongin-City (KR)
(74) Representative: Gulde Hengelhaupt Ziebig & Schneider

(57) **Abstract**

A separated target apparatus and a sputtering method using the separated target apparatus. The separated target apparatus includes a plurality of separated targets that are adhered to a base plate and that form a regular array, wherein gaps between the plurality of separated targets are disposed within an angle between a first direction that is a direction of the regular array, and a second direction perpendicular to the first direction. When sputtering is performed by using the separated target apparatus having the aforementioned structure, it is possible to obtain an uniform deposition quality on a substrate by using the separated targets that are easily manufactured and handled, and thus it is possible to make brightness of a display apparatus be uniform on an entire screen.

## Description

### BACKGROUND OF THE INVENTION

Field of the Invention

Exemplary embodiments of the present invention relate to a separated target apparatus used as a deposition source in a sputtering operation, and a sputtering method using the separated target apparatus.

Discussion of the Background

In general, a thin film transistor (TFT) that is applied to a display apparatus is manufactured via a deposition process such as magnetron sputtering. That is, sputtering is performed on a deposition target so that a thin film having a desired pattern is formed on a substrate of the display apparatus which is a deposition target object.

However, as a size of a screen of the display apparatus increases, it becomes difficult to manufacture the deposition target so as to allow the deposition target to have the same size as the screen. That is, the TFT is completely formed on the screen of the display apparatus, and in this regard, a significant load is caused in manufacturing and handling the deposition target so as to allow the deposition target to have almost the same size as the screen. Also, the use of a TFT whose active layer is formed of oxide increases, an oxide target may be more frequently used during sputtering. However, the oxide is fragile such that it is difficult to manufacture and to handle the oxide when the oxide is large.

Recently, in consideration of these problems, a separated target apparatus may be used, and in the separated target apparatus, a deposition target may be formed of a plurality of small separated targets that are easily manufactured and handled, and then adhered to a base plate. Afterward, during sputtering, the separated target apparatus performs a deposition operation while the target assembly of the separated target apparatus moves along a screen. That is, the deposition target is not formed to have a size capable of completely covering a screen but is formed by connecting small separated targets, and a size of the connected small separated targets covers only a portion of the screen. Afterward, during sputtering, the separated target apparatus performs the deposition operation while the deposition target of the separated target apparatus moves along a screen.

However, since the deposition target may be formed of a plurality of small separated targets, a quality deviation between an area corresponding to a gap between the small separated targets, and an area corresponding to an inner portion of each separated target may increase. That is, since end corners of each separated target are positioned adjacent to the area corresponding to the gap between the small separated targets, a voltage value and a magnetic field value in the gap are greater than those values in the inner portion, so that a deposition quality may become irregular.

Due to the aforementioned problems, brightness on a screen of a display apparatus that is a final product may not be uniform, and a level of a brightness deviation may increase in portion to the size of the screen.

Thus, there is a demand for a solution capable of solving these problems.

The above information disclosed in this Background section is only for enhancement of understanding of the background of the invention and therefore it may contain information that does not form any part of the prior art nor what the prior art may suggest to a person of ordinary skill in the art.

### SUMMARY OF THE INVENTION

Exemplary embodiments of the present invention provide a separated target apparatus for sputtering which uses separated targets but restrains a deposition quality deviation in portions of a screen which causes a brightness deviation.

Additional features of the invention will be set forth in the description which follows, and in part will be apparent from the description, or may be learned by practice of the invention.
According to the invention a separated target apparatus for sputtering is provided, the separated target apparatus comprises a base plate; and a plurality of separated targets disposed in a first direction on the base plate, wherein each separated target is spaced apart from adjacent separated targets by gaps, the gaps between adjacent ones of the plurality of separated targets extend along a direction at an angle between the first direction and a second direction perpendicular to the first direction.

An exemplary embodiment of the present invention discloses a separated target apparatus for sputtering. The separated target apparatus includes a base plate and a plurality of separated targets that are adhered to the base plate and that form a regular array. Gaps between the plurality of separated targets are disposed within an angle between a first direction that is a direction of the regular array, and a second direction perpendicular to the first direction.
That is, parallel edges of adjacent separated targets may extend along a direction at an angle between the first direction and a second direction perpendicular to the first direction. Preferably, the plurality of separated targets are disposed in a regular array in the first direction on the base plate.
In a further preferred embodiment an end point of one gap from among the gaps, and a start point of a next gap adjacent to the one gap are disposed on the same line in the second direction.
The plurality of separated targets may comprise triangle-shaped targets disposed at both ends of the base plate, and quadrangle-shaped targets disposed between the triangle-shaped targets. A magnet is disposed on one side of the base plate, and the plurality of separated targets are disposed on the other side of the base plate.
The magnet may be one body.
Preferably, base plate comprises a metallic material, and/ or the plurality of separated targets comprise an oxide material.

Furthermore, according to the invention a sputtering method is provided, the sputtering method comprises the steps of arranging a separated target apparatus comprising a plurality of separated targets that are disposed in a first direction on a base plate in a regular array, wherein each separated target is spaced apart from adjacent separated targets by gaps, the gaps between adjacent ones of the plurality of separated targets extend along a direction at an angle between the first direction and a second direction perpendicular to the first direction; arranging a substrate that is a sputtering target object to face the separated target apparatus; and sputtering while moving the separated target apparatus in the second direction above the substrate.
That is, the sputtering method is carried out by means of the separated target apparatus for sputtering according to the invention.

An exemplary embodiment of the present invention also discloses a sputtering method including arranging a separated target apparatus including a plurality of separated targets that are adhered to a base plate and that form a regular array, wherein gaps between the plurality of separated targets are disposed within an angle between a first direction that is a direction of the regular array, and a second direction perpendicular to the first direction; arranging a substrate that is a sputtering target object to face the separated target apparatus; and performing sputtering while moving the separated target apparatus in the second direction above the substrate.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention, and together with the description serve to explain the principles of the invention.

FIG. 1 is a plan view of a separated target apparatus according to an exemplary embodiment of the present invention.

FIG. 2 is a diagram of a vacuum chamber in which the separated target apparatus of FIG. 1 is arranged.

FIG. 3 is a plan view magnifying a portion of the separated target apparatus of FIG. 1.

FIGS. 4A and 4B are plan views illustrating a sputtering process using the separated target apparatus of FIG. 1.

FIG. 5 is a plan view of a separated target apparatus according to another exemplary embodiment of the present invention.

### DETAILED DESCRIPTION OF THE ILLUSTRATED EMBODIMENTS

Hereinafter, the present invention will be described in detail by explaining exemplary embodiments of the invention with reference to the attached drawings, in which embodiments of the invention are shown. This invention may, however, be embodied in many different forms and should not be construed as limited to the embodiments set forth herein. Rather, these embodiments are provided so that this disclosure is thorough, and will fully convey the scope of the invention to those skilled in the art. In the drawings, the size and relative sizes of layers and regions may be exaggerated for clarity. Like reference numerals in the drawings denote like elements.

It will be understood that when an element or layer is referred to as being "on" or "connected to" another element or layer, it can be directly on or directly connected to the other element or layer, or intervening elements or layers may be present. In contrast, when an element or layer is referred to as being "directly on" or "directly connected to" another element or layer, there are no intervening elements or layers present. It will be understood that for the purposes of this disclosure, "at least one of X, Y, and Z" can be construed as X only, Y only, Z only, or any combination of two or more items X, Y, and Z (e.g., XYZ, XYY, YZ, ZZ).

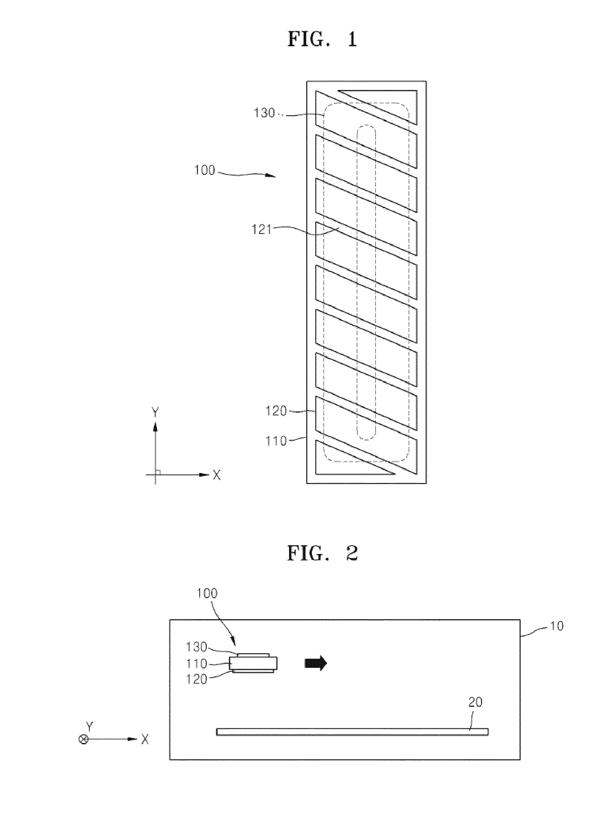

FIG. 1 illustrates a structure of a separated target apparatus for sputtering according to an exemplary embodiment of the present invention.

As illustrated in FIG. 1, the separated target apparatus for sputtering (hereinafter, referred to as 'separated target apparatus 100') includes a base plate 110 formed of a copper plate (or other suitable material, for example, another metal), a plurality of separated targets 120 which are a sputtering source and are adhered on one surface of the base plate 110, and a magnet 130 adhered on the other surface of the base plate 110.

As illustrated in FIG. 2, when sputtering is performed, the separated target apparatus 100 is arranged so as to face a substrate 20 of a display apparatus which is a sputtering target object in a vacuum chamber 10 to which an argon gas is supplied.

When a discharge is incurred by using the separated target apparatus 100 as a cathode and by using the substrate 20, which is the sputtering target object, as an anode in the vacuum chamber 10, argon ions are generated from the argon gas, the argon ions collide with the separated targets 120 of the separated target apparatus 100 and thus scatter particles of the separated targets 120, and the scattered particles are deposited on the substrate 20, so that a thin film is formed. The magnet 130 functions to form an electric filed so as to increase a sputtering speed due to collision of the argon ions. The aforementioned sputtering in which the deposition is performed while a voltage value and the electric field are applied to the sputtering target object is referred to as magnetron sputtering, and unlike the separated targets 120, the magnet 130 is not separated but is formed as one body.

As illustrated in FIG. 2, the separated target apparatus 100 has a size that is not the same size as the substrate 20 and that may cover only a portion of the substrate 20. During the sputtering, the separated target apparatus 100 performs a scanning operation above the substrate 20 while the separated target apparatus 100 moves in an X-axis direction of FIG. 2. That is, the substrate 20 and the separated target apparatus 100 that face each other are not formed to have the same size, but instead are formed in such a manner that the separated target apparatus 100 covers only a portion of the substrate 20, and the separated target apparatus 100 performs the scanning operation above the substrate 20 so as to cover an entire area of the substrate 20. Here, the movement of the separated target apparatus 100 with respect to the substrate 20 is relative movement, so that the separated target apparatus 100 may be fixed while the substrate 20 moves in the X-axis direction.

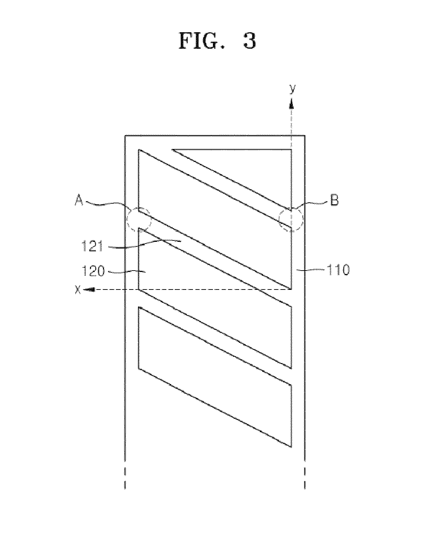

As illustrated in FIGS. 1 and 3, the sputtering source adhered to the separated target apparatus 100 is formed of the plurality of separated targets 120, and this facilitates handling of an oxide target. That is, as described above, due to increases in incidences of a thin film transistor (TFT) whose active layer is formed of oxide, the oxide target is more frequently used during sputtering. However, the oxide is fragile such that it is difficult to manufacture and to handle the oxide when the oxide is large. However, according to the present embodiment in which the separated target apparatus 100 is formed by adhering the separated targets 120 to the base plate 110, it is only necessary to handle the separated targets 120 that are small, so that the manufacturing and handling of the separated targets 120 are significantly more convenient compared to manufacturing and handling of a large target.

However, in a case of using the separated targets 120, in conventional separated target apparatus, irregular deposition may be incurred due to gaps 121 between the separated targets 120. That is, since end corners of each separated target 120 are positioned in an area adjacent to the gap 21 between the separated targets 120, a voltage value and a magnetic field value in the gap 121 are greater than those values in an inner portion of each separated target 120. Due to this difference, a sputtering result may be irregular, and according to the present embodiment, in order to solve the irregularity problem, the gaps 121 between the separated targets 120 are arranged to be parallel.

That is, as illustrated in FIGS. 1 and 3, when it is assumed that a column direction (a Y-axis direction) in which the separated targets 120 are arrayed in a line is referred to as a first direction, and a direction (the X-axis direction) in which the separated target apparatus 100 moves above the substrate 20 is referred to as a second direction, the gaps 121 are all arrayed to be parallel to each other and oriented at an angle between the first direction and the second direction. In order to allow all of the gaps 121 between the separated targets 120 to be parallel on the base plate 110 having a quadrangular shape, the separated targets 120 at both ends in the first direction (the Y-axis direction) have a triangular shape, and the rest of the separated targets 120 have a quadrangular shape. However, as long as the gaps 121 may maintain their parallel status, the separated targets 120 at both ends may also have a quadrangular shape by cutting their outer vertex portions. However, by doing so, a sputtering area is decreased, so that, in the present embodiment, the separated targets 120 at both ends have a triangular shape.

As illustrated in FIG. 3, an end point "A" of one gap 121 from among the gaps 121 between the separated targets 120, and a start point "B" of a next gap 121 adjacent to the one gap 121 are disposed on the same line in the second direction (the X-axis direction). By doing so, when it is assumed that the separated target apparatus 100 is rolled up, a spiral shape at which the gaps 121 are connected as one body is formed.

In this manner, distribution of the gaps 121 between the separated targets 120 in the separated target apparatus 100 is uniform in both the first direction (the Y-axis direction) and the second direction (the X-axis direction). That is, since an array of the gaps 121 is not gathered on a line in the first direction (the Y-axis direction) or the second direction (the X-axis direction) but is sloped to form the spiral shape, the distribution of the gaps 121 may be uniform in both horizontal and vertical directions. The fact that the distribution of the gaps 121 is uniform means that an effect due to the gaps 121 is equally applied to an area facing the separated target apparatus 100, thus, uniform sputtering may be possible.

Also, when the separated target apparatus 100 moves in the second direction (the X-axis direction) so as to perform sputtering, the slope array of the gaps 121 may function to disperse the effect due to the gaps 121.

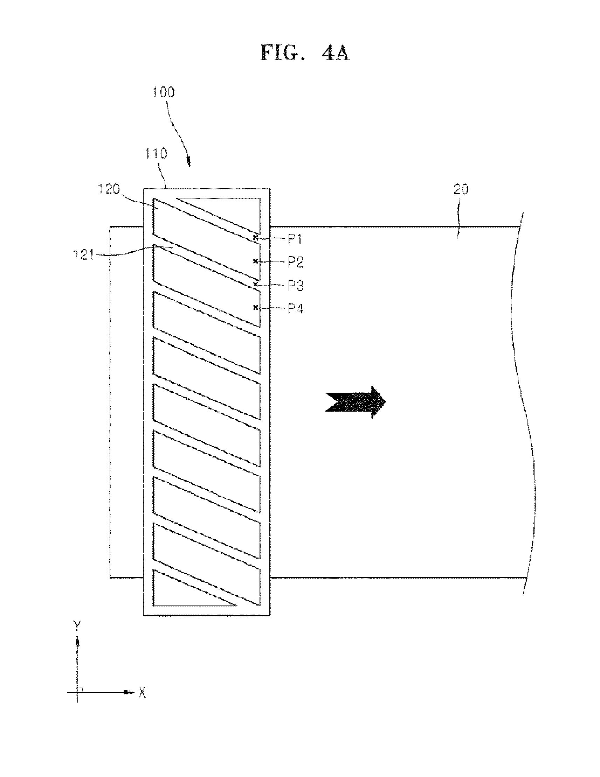

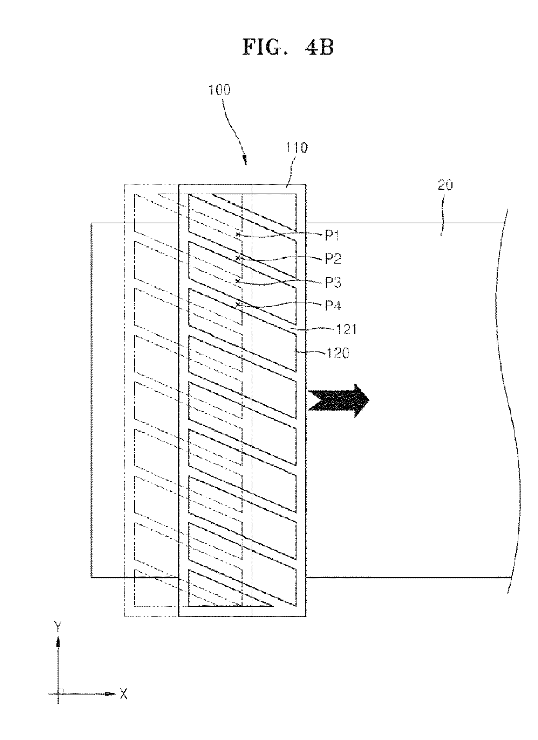

FIGS. 4A and 4B are diagrams describing a dispersion effect during sputtering.

FIGS. 4A and 4B are plan views in which the base plate 110 is disposed above the substrate 20 and separated targets 120 are disposed below the base plate 110. Although it is required to indicate the separated targets 120 by using a dotted line, for convenience of illustration, the separated targets 120 are shown by using a solid line, and the magnet 130 is omitted.

First, while the substrate 20 and the separated target apparatus 100 face each other in the vacuum chamber 10 (refer to FIG. 2), the sputtering starts. When the sputtering starts, the separated target apparatus 100 moves in a second direction (an X-axis direction). FIG. 4A illustrates a situation in which the separated target apparatus 100 moves. Here, P1 I and P3 points of the substrate 20 are disposed to correspond to the gaps 121 between the separated targets 120, and P2 and P4 points of the substrate 20 are disposed to correspond to inner areas of the separated targets 120. Thus, in this situation, a voltage value and a magnetic field value of the P1 and P3 points are relatively greater than those values of the P2 and P4 points.

However, referring to FIG. 4B illustrating a situation in which the separated target apparatus 100 further moves in the second direction (the X-axis direction), compared to the situation of FIG. 4A, the P2 and P4 points of the substrate 20 are disposed to correspond to the gaps 121 of the separated targets 120, and the P1 and P3 points are disposed to correspond to the inner areas of the separated targets 120. Thus, in this situation, the voltage value and the magnetic field value of the P2 and P4 points are relatively greater than those values of the P1 and P3 points.

In this manner, while the separated target apparatus 100 moves above the substrate 20, the sputtering is not proceeded in a manner that one point of the substrate 20 constantly corresponds to the gap 121 while the other point of the substrate 20 constantly corresponds to an inner area of the separated target 120, but instead the sputtering is proceeded in a manner that a point corresponding to the gap 121 and a point corresponding to an inner area of the separated target 120 are repetitively changed. Thus, the effect of the gaps 121 is equally applied to an entire area of the substrate 20.

In other words, the separated targets 120 that are easily manufactured and handled are collectively used while the effect due to the gaps 121 during the sputtering is dispersed to the entire area of the substrate 20, thus, an occurrence of irregular sputtering may not be converged into a specific point of the substrate 20.

By doing so, irregular sputtering due to the fact that a voltage value and a magnetic field value relatively increase in the gap 121 between the separated targets 120 may be solved, and accordingly, uniform sputtering may be possible by using the separated targets 120, so that uniform brightness may be realized in the entire area of the substrate 20.

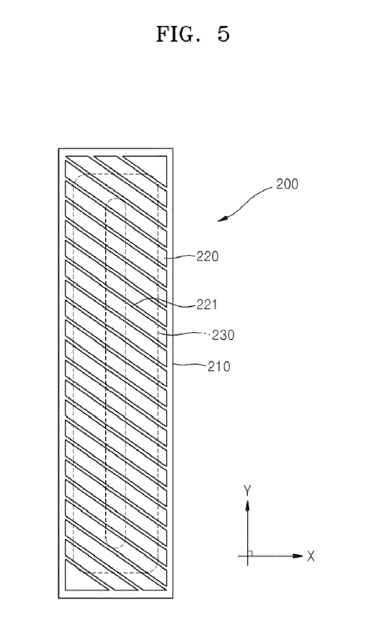

According to the present embodiment, as illustrated in FIG. 3, the end point A of the one gap 121, and the start point B of the next gap 121 adjacent to the one gap 121 are disposed on the same line in the second direction (the X-axis direction), so as to allow the gaps 121 to form the spiral shape. However, this is optional. That is, as illustrated in FIG. 5, although an end point of one gap 221 and a start point of a next gap 221 adjacent to the one gap 221 are not disposed on the same line in the second direction, if the gaps 221 of separated targets 220 are arrayed within an angle between a first direction (an Y-axis direction) and a second direction (an X-axis direction), it is possible to obtain a result by which an effect due to the gaps 221 may be equally dispersed to the entire area of the substrate 20. When it is assumed that a separated target apparatus 200 is rolled up, although an end point and a start point between the adjacent gaps 221 are not exactly lined up with each other in the second direction, if the gaps 221 on a base plate 210 are arrayed to be parallel to each other in a diagonal direction, since a point of the substrate 20 which corresponds to the gap 221 during sputtering, and a point of the substrate 20 which corresponds to an inner area of the separated target 220 are repetitively changed, an occurrence of irregular sputtering due to the effect of the gaps 221 may be sufficiently decreased. In FIG. 5, reference numeral 230 indicates a magnet.

By using the separated target apparatuses 100 and 200 having the aforementioned improved structures with respect to the gaps 121 and 221, it is possible to obtain an uniform deposition quality on the substrate 20 by using the separated targets 120 and 220 that are easily manufactured and handled, and thus it is possible to make brightness of the display apparatus be uniform on an entire screen. In particular, the separated target apparatuses 100 and 200 may be usefully applied to a case in which an oxide having great fragility is used as a target.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A separated target apparatus (100) for sputtering, the separated target apparatus (100) comprising:
a base plate (110, 210); and
a plurality of separated targets (120, 220) disposed in a first direction (Y) on the base plate (110, 210),
wherein each separated target (120, 220) is spaced apart from adjacent separated targets (120, 220) by gaps (121, 221), the gaps (121, 221) between adjacent ones of the plurality of separated targets (120, 220) extend along a direction at an angle between the first direction (Y) and a second direction (X) perpendicular to the first direction (Y).

2. The separated target apparatus of claim 1, wherein the plurality of separated targets (120, 220) are disposed in a regular array in the first direction (Y) on the base plate (110, 210).

3. The separated target apparatus of one of the preceding claims , wherein an end point of one gap (121, 221) from among the gaps, and a start point of a next gap (121, 221) adjacent to the one gap (121, 221) are disposed on the same line in the second direction (X).

4. The separated target apparatus of one of the preceding claims, wherein the plurality of separated targets (120, 220) comprise triangle-shaped targets disposed at both ends of the base plate (110, 210), and quadrangle-shaped targets disposed between the triangle-shaped targets.

5. The separated target apparatus of one of the preceding claims, wherein a magnet (130, 230) is disposed on one side of the base plate (110, 210), and the plurality of separated targets (120, 220) are disposed on the other side of the base plate (110, 210).

6. The separated target apparatus of claim 4, wherein the magnet 130 is one body.

7. The separated target apparatus of one of the preceding claims, wherein the base plate (110, 210) comprises a metallic material.

8. The separated target apparatus of one of the preceding claims, wherein the plurality of separated targets (120, 220) comprise an oxide material.

9. A sputtering method comprising:
arranging a separated target apparatus (100) comprising a plurality of separated targets (120, 220) that are disposed in a first direction (Y) on a base plate(110, 210) , wherein each separated target (120, 220) is spaced apart from adjacent separated targets (120, 220) by gaps (121, 221), the gaps (121, 221) between adjacent ones of the plurality of separated targets (120, 220) extend along a direction at an angle between the first direction (Y) and a second direction (X) perpendicular to the first direction (Y);
arranging a substrate (20) that is a sputtering target object to face the separated target apparatus (100); and
sputtering while moving the separated target apparatus (100) in the second direction (X) above the substrate.
